(19) **Europäisches Patentamt**

**European Patent Office**

**Office européen des brevets**

(11) **EP 0 603 422 B1**

(12) **EUROPEAN PATENT SPECIFICATION**

(45) Date of publication and mention
of the grant of the patent:
**24.05.2000 Bulletin 2000/21**

(51) Int. Cl.$^7$: **C23C 16/26**, C23C 16/52

(21) Application number: **92121635.4**

(22) Date of filing: **18.12.1992**

(54) **Wear component and method of making same**

Verschleissteil und Verfahren zu seiner Herstellung

Pièce d'usure et son procédé de fabrication

(84) Designated Contracting States:
**DE FR GB**

(73) Proprietor: **NORTON COMPANY**
**Worcester, MA 01615-0008 (US)**

(72) Inventor: **Simpson, Matthew**
**Arlington, MA 02174 (US)**

(74) Representative:
**DIEHL GLAESER HILTL & PARTNER**
**Patentanwälte**
**Augustenstrasse 46**
**80333 München (DE)**

(43) Date of publication of application:
**29.06.1994 Bulletin 1994/26**

(56) References cited:
**EP-A- 0 319 926**     **EP-A- 0 379 220**
**EP-A- 0 449 571**

- **THIN SOLID FILMS vol. 146, no. 1, 2 January 1987, LAUSANNE pages 27 - 43 D.NIR 'intrinsic stress in diamond like carbon films and its dependance on deposition parameters'**
- **APPLIED POLYMER SYNOPSIS vol. 46, 1990, NEW YORK pages 273 - 288 T.WYDEVEN ET AL 'transmission, hardness and compressive stress of amorphous hydrocarbon films grown from mixtures of a hydrocarbon vapour and permanent gases'**
- **THIN SOLID FILMS vol. 215, no. 2, 14 August 1992, LAUSANNE pages 174 - 178 W.WANLU ET AL 'internal stress analysis in diamond films formed by d.c.plasma chemical vapour deposition'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

This invention relates to a wear component and a method of making same. Furthermore, the invention relates to a method for producing synthetic diamond for use as a wear surface, and a method of investigating synthetic diamond to be utilized as a wear surface.

The use of natural diamond in wear components, such as in cutting and grinding tools, is very old. In addition to extreme hardness, diamond's superlative thermal conductivity, thermal stability, and inertness are unsurpassed for wear applications. In recent times synthetic polycrystalline diamond films have been successfully produced, such as by chemical vapor deposition (CVD), and used commercially in wear applications. The synthetic diamond films can be deposited directly on the base of a wear component, for example as a thin film (generally defined as a film having a thickness of less than 20 μm), or produced separately, generally as a thick film, and mounted on the base of a wear component, such as by brazing.

Even exceedingly hard diamond surfaces have a limited wear life, and the wear life of synthetic diamond, which can vary considerably for different synthetic diamond material, is a key factor in the cost-effectiveness of a wear component. A number of factors are recognized as affecting the wear life of synthetic diamond. The presence of foreign matter, voids, and cracks are all usually deleterious to the wear resistance of diamond. In this context, foreign matter also includes carbon not possessing the diamond structure, such as graphite.

Document EP 0 379 220 A1 discloses a diamond coated sintered body characterized by having a diamond film formed by a gas phase synthesis method on the surface of a sintered body obtained from a mixture of tungsten carbide and at least one compound selected from the group consisting of carbide and nitride of silicon or boron and, if necessary, additionally at least one compound selected from the group consisting of carbide, oxide, nitride, carbonitride, carbonate, boride and organic compound of at least one element selected from the group consisting of metals and rare earth elements belonging to Groups Ia, IIa, IIIa, IVa, Va, IIIb and IVb of the Mendelejeff's periodic table.

However, wear resistance of the diamond film is not addressed.

Document EP 0 449 571 A1 discloses a polycrystalline diamond tool wherein polycrystalline diamond has non-uniform quality along the direction of thickness. The diamond near the rake surface is of better quality. The diamond near the fixation surface is of worse quality. The worse diamond near the fixation surface alleviates a strong stress or absorbs an external shock. Owing to the worse diamond near the fixation surface, the diamond tool excels in chip resistance or toughness. The better diamond near the rake surface heightens abrasion resistance, adhesion resistance and strength.

Document EP 0 319 926 A2 discloses a method for the preparation of a diamond-clad machining tool. The diamond-clad machining tool of the invention is prepared by the steps of (a) forming a film of diamond of 10 to 1000 μm thickness by the method of vapor-phase deposition on the surface of a temporary substrate of, e.g., silicon, (b) bonding the diamond film as borne by the temporary substrate to the surface of a base body of the tool by brazing and (c) removing the temporary substrate, e.g., by grinding to leave the diamond film bonded to the base body of the tool by brazing. The method is advantageous in the versatility in respect of the material of substrate on which a diamond film is deposited from the vapor phase as well as in the firmness of bonding between the cladding layer and the base body of the tool in comparison with the conventional vapor-phase deposition method of diamond directly to the surface of the base body of a tool.

Improvement of the wear resistance of the diamond film is not discussed in this document.

It is therefore the object of the present invention to provide synthetic diamond having improved wear properties. A further object is to provide an improved method of making such diamond.

These objects are solved by the method of making a wear component according to independent claim 7, a wear component according to independent claim 1, the method for producing synthetic diamond for use as a wear surface according to independent claim 16. Further advantageous features, aspects and details of the invention are evident from the dependent claims, the description, examples and the drawings.

Generally spoken, the invention provides improvements in wear components comprising synthetic diamond wear surfaces and a method of making such improved wear components. Particularly, the invention provides improved synthetic diamonds for use in wear components and methods of making such diamond.

Applicant has discovered that the wear properties of synthetic diamond are related to the equivalent strain in the diamond crystal structure in an unexpected way, and this discovery is utilized in the invention to produce diamond with superior wear characteristics, as well as to monitor and modify processes of diamond deposition to obtain improved wear surfaces and wear components. [As used herein, a wear surface is intended to mean a surface employed for tribological application; for example, without limitation, a cutting surface, a grinding surface, a bearing surface or a valve surface. A wear component is intended to mean a wear surface secured to a base element; for example, without limitation, a cutting component, a grinding component, a bearing component, or a valve component.] Surprisingly, a certain minimum equivalent strain in the crystal lattice (that is, a displacement of atom positions with respect to positions they would occupy in a perfect lattice) results in improvement of the wear characteristics of synthetic diamond, rather than a degrading of wear characteristics that might be expected from lattice imperfection. In most ceramic applications, less perfect crystals exhibit poorer wear resistance.

A relatively high thermal conductivity can contribute to improvement of the wear characteristics of synthetic diamond. Applicant has demonstrated that the obtainment of diamond having substantial equivalent strain improves wear characteristics for synthetic diamond film of a given thermal conductivity. Measurements of equivalent strain can also be used in the monitoring and control of synthetic diamond film production and in selection of synthetic diamond for wear applications.

In accordance with a form of the invention, a method is set forth for making a wear component. A base surface is provided. A synthetic diamond film is produced, the film having a thickness of at least 20 μm and an equivalent strain of at least 0.08 percent. The synthetic diamond film is applied to the base surface. The film can be deposited directly on the base surface, for example by having the base surface be the target surface in a chemical vapor deposition system. More typically, for thick film synthetic diamond, the film can be separately produced and then mounted on the base surface, such as by brazing a piece of synthetic diamond film to a tungsten carbide base surface in a manner well known in the art.

It is preferable to form a diamond film wear surface having a thermal conductivity of at least about 9 W/cm°K. For thermal conductivities less than about 9 W/cm°K, the diamond film should be formed with an equivalent strain of at least about 0.10 percent to exhibit improved wear characteristics in accordance with the principles hereof.

In a further form of the invention, there is set forth a method for producing synthetic diamond film for use as a wear surface. Synthetic diamond is formed by chemical vapor deposition using initial deposition parameters. The equivalent strain of the diamond film is monitored, for example by measuring equivalent strain of each sample produced or of a sample from a produced batch. The deposition parameters are then modified when the equivalent strain of the synthetic diamond is less than a predetermined minimum percentage. In an embodiment hereof, the minimum equivalent strain percentage is about 0.08 percent. In a form of the invention, the thermal conductivity of the diamond is also measured. In this embodiment, the referenced minimum equivalent strain percentage is about 0.08 percent when the thermal conductivity is greater than about 9 W/cm°K, and the referenced minimum equivalent strain percentage is about 0.10 percent when the thermal conductivity is less than about 9 W/cm°K. The deposition parameters to be modified include at least one parameter selected from the group consisting of the ratio of feedstock gases for chemical vapor deposition and the deposition temperature.

In accordance with a further form of the invention, a method is set forth for inspecting synthetic diamond to be utilized as a wear surface to select synthetic diamond that is expected to have superior wear properties. In accordance with this method, synthetic diamond having an equivalent strain of greater than a predetermined percentage is selected for use in certain wear application(s), whereas the synthetic diamond that does not meet the predetermined criteria (as described above) can be used for applications where the superior wear properties are not required, such as in lower cost wear components.

Further features and advantages of the invention will become more readily apparent from the following detailed description when taken in conjunction with the accompanying drawings.

Fig. 1 is a schematic diagram of a plasma jet deposition system of a type which can be utilized in practicing an embodiment of the invention.

Fig. 2 is a top view of a wear component of a type typically utilized as an insert for a milling machine cutting tool.

Fig. 3 is a side view of the wear component of Fig. 2.

Fig. 4 is an operational flow diagram of a procedure in accordance with an embodiment of the invention for producing synthetic diamond having improved wear characteristics.

Fig. 5 is an operational flow diagram of a procedure of the invention for selecting synthetic diamond based on suitability for wear applications.

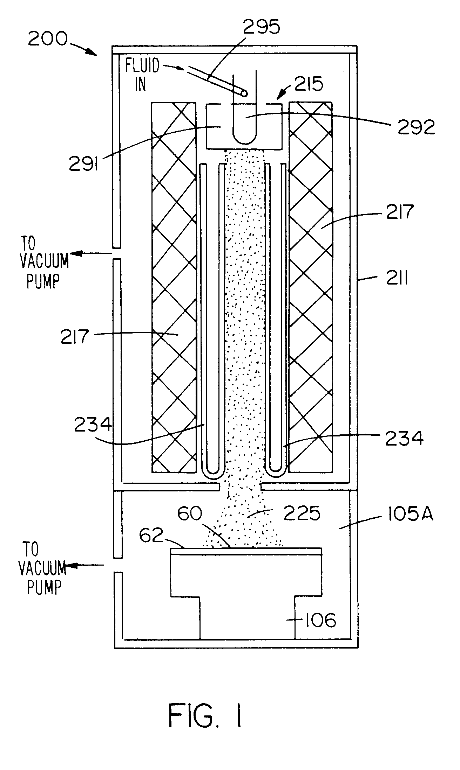

Referring to Fig. 1, there is shown a diagram of a plasma jet deposition system 200 of a type which can be utilized in practicing an embodiment of the invention. Reference can also be made to U.S. Patent No.s 4,471,003 and 4,487,162. The system 200 is contained within a vacuum housing 211 and includes an arc-forming section 215 which comprises a cylindrical anode 291, a rod-like cathode 292, and an injector 295 mounted adjacent the cathode so as to permit injected fluid to pass over the cathode 292. In the illustrated system the input fluid may be a mixture of hydrogen and methane. The anode 291 and cathode 292 are energized by a source of electric potential (not shown), for example a DC potential. Cylindrical magnets, designated by reference numeral 217, are utilized to control the plasma generated at the arc forming section. The magnets maintain the plasma within a narrow column until the plasma reaches the deposition region 60. Cooling coils 234, in which liquid nitrogen can be circulated, are located within the magnets and surround the focused plasma.

In operation, a mixture of hydrogen and methane is fed to the injector 295, and a plasma is obtained in front of the arc forming section and accelerated and focused toward the deposition region. The temperature and pressure at the plasma formation region are typically in the approximate ranges 1500-2700 °C and 133-931 mbar (100-700 torr), respectively, and in the deposition region are in the approximate ranges 800-1100°C and 13.3-266 mbar (10-200 torr), respectively. As is known in the art, synthetic polycrystalline diamond can be formed from the described plasma, as the carbon in the methane is selectively deposited as diamond, and the graphite which forms is dissipated by combination with the hydrogen facilitating gas.

The bottom portion 105A of the chamber has a base 106 that can mount a medium 62 on which the synthetic diamond is to be deposited. The base can include a temperature controller. The medium 62 may be, for example, the base of a tool, an insert for a tool, the base of a bearing surface, etc. Alternatively, the medium 62 can be a substrate, such as molybdenum or graphite, on which synthetic diamond can be deposited, removed, and applied to a base to form a wear surface, such as for a tool or bearing or other wear component.

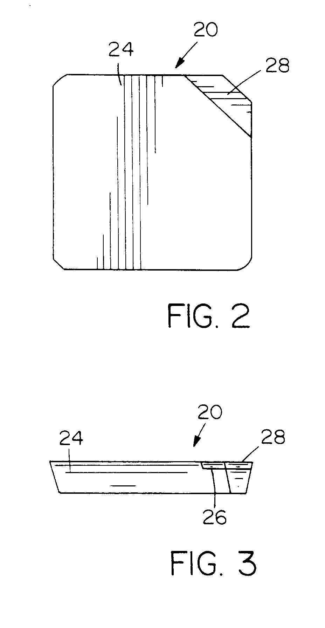

Figs. 2 and 3 illustrate an example of a wear component 20 of a type typically utilized as an insert for a milling machine. A tungsten carbide element or body 24 is provided in a generally rectangular shape with a chamfered corner having a depression 26 that receives a piece of diamond 28 that serves as a cutter. As is known in the art, the diamond 28 can be synthetic polycrystalline diamond film. The diamond can be deposited directly on the element 24 or, more typically for diamond thick films, a piece of synthetic diamond film that is mounted, such as by brazing, on the element 24.

In accordance with the improvement of a form of the present invention, the diamond wear surface comprises a polycrystalline synthetic diamond thick film (i.e. a film at least 20 μm thick) having an equivalent strain of at least 0.08 percent. For thick film synthetic diamond wear surfaces having a thermal conductivity greater than about 9 W/cm°K the equivalent strain should be at least about 0.08 percent to obtain superior wear characteristics. When the thermal conductivity is less than about 9 W/cm°K, an equivalent strain of at least about 0.10 percent is needed to provide the desired superior wear characteristics. The relationship between equivalent strain and wear properties is particularly significant at substantial thick film thicknesses, viz. greater than about 200 μm.

As is known in the art, certain operating parameters of the plasma jet deposition equipment, or of other chemical vapor deposition equipments, are generally adjustable, such as by varying the ratio of feedstock gasses [for example, the relative percentages of hydrogen and methane], varying the temperature, and/or varying the pressure of the plasma and/or the target (e.g. the medium 62 in Fig. 1). In accordance with an aspect of the present invention, operating conditions are adjusted to obtain the desired minimum equivalent strain percentage. Increasing the deposition temperature tends to increase equivalent strain.

In an embodiment hereof, equivalent strain is measured as follows: X-ray diffraction measurements are made using Cu Ka radiation (45kV, 40mA on the tube) on a Philips PW1700 X-ray diffraction analyzer machine. The patterns are recorded for the diamond as grown (i.e. without crushing). The angle 2θ is scanned in 0.04 degree steps, dwelling 1 second at each step. Data are corrected in a standard manner using the Philips program provided for the user of the machine. In particular, a correction using the Lorentz polarization factor is made and the Ka2 peaks are stripped assuming the Ka2/Ka1 ratio is 0.5. Instrument broadening is estimated using 5-10 μm diamond powder as a standard. Finally, the integral breadth d of the 331 reflection is measured and the equivalent strain e computed from it assuming all of the broadening is induced by strain, using the formula

$$d = (e/4)\tan\theta$$

where θ is the usual diffraction angle, that is, 70.2 degrees for the 331 reflection. [See H.P. Klug, L.A. Alexander "X-ray Diffraction Procedures for Polycrystalline and Amorphous Materials", p661, Wiley-Interscience, New York, 1974.] The technique of measurement of equivalent strain is not, of itself, an inventive feature hereof, and it will be understood that any suitable technique for determining equivalent strain can be used, consistent with the principles of the invention.

It is known that an increase in the thermal conductivity can be achieved in CVD diamond by varying the chemistry of the depositing gas. For example, additions of oxygen and reductions in carbon content are both known methods of increasing thermal conductivity of CVD diamond. Thermal conductivity in an embodiment hereof is measured by a method described in Enguhard et al, Materials Science & Engineering, Volume B5, pp. 127-134 (1990).

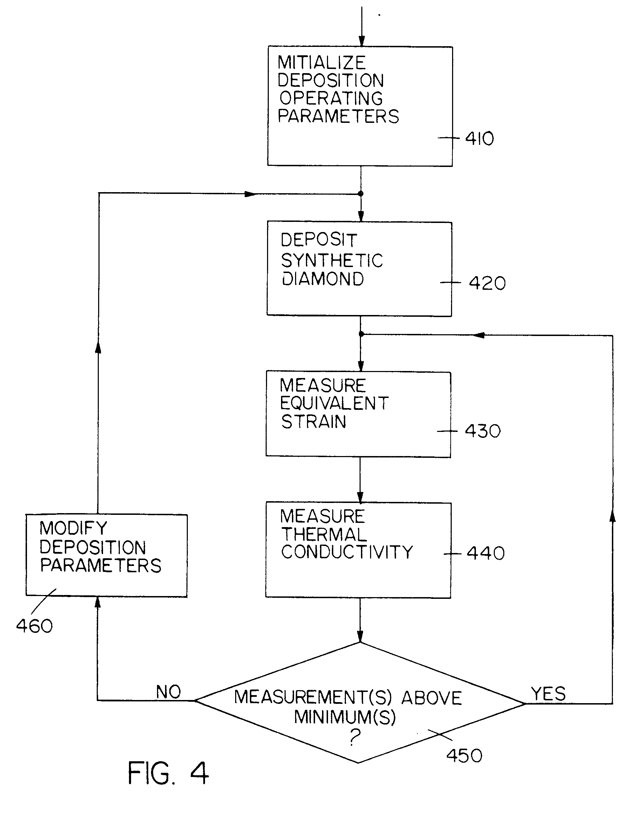

Fig. 4 is an operational flow diagram of a procedure in accordance with an embodiment of the invention for producing synthetic diamond having improved wear characteristics. The block 410 represents the initializing of deposition operating parameters, for example the operating parameters of the Fig. 1 arc jet plasma deposition equipment. These parameters may include, inter alia, the ratio of feedstock gases, the control of temperature, and the control of pressure. The block 420 represents the deposition of synthetic diamond, and the block 430 represents the measurement of the equivalent strain of the synthetic diamond. The thermal conductivity of the synthetic diamond can also be measured, as represented by the block 440. If the measured equivalent strain percentage is below a predetermined threshold (which, as noted above, may also take into account the thermal conductivity), a decision is made (represented by decision block 450) to modify the deposition parameters. For example, the deposition temperature can be raised, which tends to increase the equivalent strain of the resultant CVD diamond. Also, the percentage of methane in the feedstock gases can be increased, if necessary, to increase the thermal conductivity of the resultant CVD diamond. When the equivalent strain is above the desired minimum, the process can be periodically monitored, as represented by re-entry to the block 420.

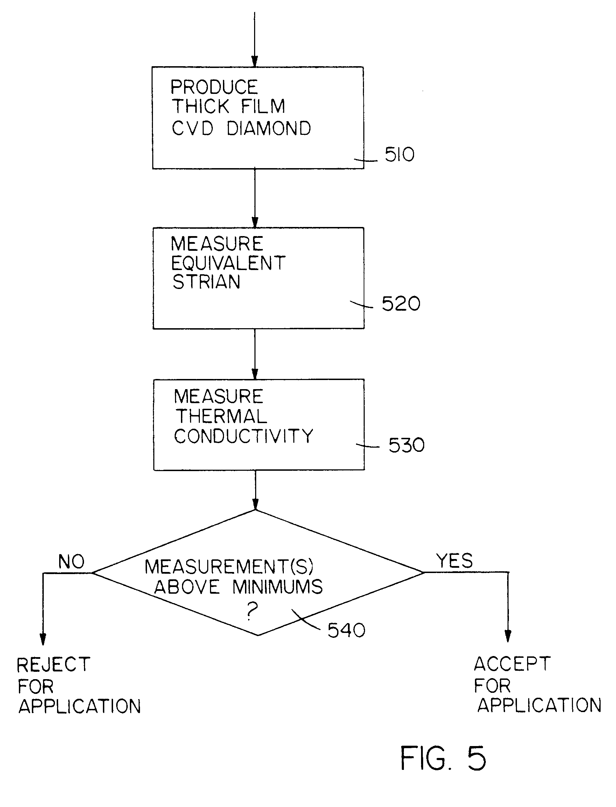

In accordance with a further aspect of the invention, and as represented by the operational flow diagram of Fig. 5, measurement of equivalent strain is utilized in selecting diamond samples (or selecting batches or production runs from which samples are taken) for suitability in wear applications. Diamond samples (or runs or batches) which do not meet equivalent strain criteria can be used in applications where some compromise in wear properties may be acceptable, such as in lower cost wear components. The block 510 represents the production of thick film polycrystalline diamond. The block 520 represents the performance of testing for equivalent strain on a sample of the produced polycrystalline synthetic diamond. Thermal conductivity can also be measured, as represented by block 530. If the measured equivalent strain percentage is above a predetermined threshold (which, as noted above, may also take into account the thermal conductivity), the diamond can be accepted for a particular wear surface application or, conversely, rejected for such application (decision block 540).

EXAMPLES

Equipment of the type shown in Fig. 1, but without cooling coils, was utilized to produce synthetic diamond samples that were subjected to a number of wear tests. The tests performed on the samples were as follows:

Milling Test

The diamond sample, at least 250 $\mu$m thick, is ground flat and parallel within 10 $\mu$m, and polished on one side. The sample is then mounted with the finest grains uppermost by brazing on a tungsten carbide insert as illustrated in Figs. 2 and 3. The insert is mounted as a single tooth in a vertical spindle mill running at 1500 m/min. with an infeed of .25 mm/rev. and 1 mm depth of cut for a single tooth. The workpiece diameter is 100 mm. Performance is determined by implementing 100 passes of the tool head over a continuous cast A390 aluminum alloy workpiece and measuring the wear on the insert using a toolmaker's microscope.

Sandblast Test

The side of the sample that was in contact with the substrate is blasted with 120 grit SiC flowing at a rate of about 3 g/min. Air pressure is about 552 kPa (80 psig) and the nozzle size is about 0.7 mm. Performance is determined by blasting for 25 minutes at a standoff of 2 cm and measuring the depth of the pit so formed in $\mu$m.

EXAMPLE 1

Samples 1-1 and 1-2 were produced using the following conditions of the DC arc jet plasma deposition equipment

|  | Sample 1-1 | Sample 1-2 |
|---|---|---|
| Gas enthalpy | 40.8 kJ/g | 40.7 kJ/g |
| %CH$_4$ in H$_2$ | 0.16 | 0.16 |
| Pressure | 26.6 mbar (20 Torr) | 26.6 mbar (20 Torr) |
| Deposition temp. | 1050°C | 1050°C |

The samples were measured and tested to determine equivalent strain thermal conductivity, and milling wear, using the measurements and tests first described above. The results were as follows:

|  | Sample 1-1 | Sample 1-2 |
|---|---|---|
| Eq. strain | .13 | .08 |

(continued)

|  | Sample 1-1 | Sample 1-2 |
|---|---|---|
| Thermal cond. | 5.8 W/cm°K | 5.3 W/cm°K |
| Milling wear | .0196 cm (.0077 in.) | .0307 cm (.0121 in.) |

It is seen from this example that two materials made under similar conditions can have substantially differences in equivalent strain. The material with higher equivalent strain exhibited much better performance in the milling test. Specifically, the sample 1-2 had about 57% more wear than the sample 1-1.

EXAMPLE 2

Samples 2-1 and 2-2 were produced using the following conditions of the DC arc jet plasma deposition equipment

|  | Sample 2-1 | Sample 2-2 |
|---|---|---|
| Gas enthalpy | 178 kJ/g | 170 kJ/g |
| %CH$_4$ in H$_2$ | 0.2 | 0.35 |
| Pressure | 5.99 mbar (4.5 Torr) | 3.86 mbar (2.9 Torr) |
| Deposition temp. | 900°C | 1050°C |

The samples were measured and tested to determine equivalent strain, thermal conductivity and sandblast test performance, using the measurements and tests first described above. In this Example (only) thermal conductivity was measured using a method more suitable for smaller samples, and described in Frederikse et al., Applied Optics, V27, pp. 4672-4675 (1988). The results were as follows:

|  | Sample 2-1 | Sample 2-2 |
|---|---|---|
| Eq. strain | <0.03 | .12 |
| Thermal cond. | 3.7 W/cm°K | 4.5 W/cm°K |
| Sandblast pit depth | 85 μm | 65 μm |

The samples 2-1, made at substantially lower deposition temperature than sample 2-2 or the samples of Example 1, exhibited much lower equivalent strain than the other samples. Again, the sample with lower equivalent strain (2-1) exhibited greater wear; viz., about 30% deeper pit depth than sample 2-2. The lower pressure in making sample 2-2 is believed to have contributed to this sample having a higher thermal conductivity notwithstanding the lower percentage of methane used in making sample 2-1.

EXAMPLE 3

Samples 3-1 and 3-2 were produced using the following conditions of the DC arc jet plasma deposition equipment

|  | Sample 3-1 | Sample 3-2 |
|---|---|---|
| Gas enthalpy | 46 kJ/g | 41 kJ/g |

(continued)

|  | Sample 3-1 | Sample 3-2 |
|---|---|---|
| %CH$_4$ in H$_2$ | 0.07 | 0.17 |
| Pressure | 26.6 mbar (20 Torr) | 13.3 mbar (10 Torr) |
| Deposition temp. | 1050°C | 1050°C |

The samples were measured and tested to determine equivalent strain, thermal conductivity and milling wear, using the measurements and tests first described above. The results were as follows:

|  | Sample 3-1 | Sample 3-2 |
|---|---|---|
| Eq. strain | .099 | .093 |
| Thermal cond. | 11.0 W/cm°K | 7.0 W/cm°K |
| Milling wear | .0185 cm (.0073 in.) | .0251 cm (.0099 in.) |

In this example the samples differ mainly in thermal conductivity and, as expected, the material having substantially higher thermal conductivity performed considerably better in the milling wear test. Sample 3-2 had about 35% more wear than sample 3-1.

EXAMPLE 4

Samples 4-1 and 4-2 were produced using the following conditions of the DC arc jet plasma deposition equipment

|  | Sample 4-1 | Sample 4-2 |
|---|---|---|
| Gas enthalpy | 34 kJ/g | 35 kJ/g |
| %CH$_4$ in H$_2$ | 0.081 | .088 |
| Pressure | 13.3 mbar (10 Torr) | 13.3 mbar (10 Torr) |
| Deposition temp. | 900°C | 1050°C |

The samples were measured and tested to determine equivalent strain, thermal conductivity and milling wear using the measurements and tests first described above. The results were as follows:

|  | Sample 4-1 | Sample 4-2 |
|---|---|---|
| Eq. strain | .042 | .17 |
| Thermal cond. | 12 W/cm°K | 8.5 W/cm°K |
| Milling wear | .0287 cm (.0113 in.) | .0216 cm (.0085 in.) |

This example shows two materials with thermal conductivities greater than 8.5 W/cm K and differing equivalent strains. The sample with lower equivalent strain (4-1) exhibited about 33% more milling wear.

In summary, the invention, in its various aspects, has been based upon the surprising discovery that synthetic diamond films having at least a certain equivalent strain percentage have substantially better wear properties than seemingly more "perfect" synthetic diamond films having a lower equivalent strain percentage.

The invention has been described with reference to particular preferred embodiments, but variations will occur to those skilled in the art. For example, it will be understood that other types of chemical vapor deposition, such as microwave plasma deposition or hot filament deposition, can be utilized to produce synthetic diamond film.

**Claims**

1. A wear component (20), comprising:

   a base surface; and

   a synthetic diamond film mounted on said base surface, said diamond film having a thickness of at least 200 μm and an equivalent strain of at least 0.08 percent, the synthetic diamond film having an equivalent strain of at least 0.08 percent being obtainable by the following steps:

   depositing synthetic diamond by chemical vapor deposition utilizing initial deposition parameters;

   monitoring the equivalent strain of the synthetic diamond;

   modifying at least one of said deposition parameters when the equivalent strain of the synthetic diamond is less than a predetermined percentage; and

   depositing further synthetic diamond utilizing the modified deposition parameters.

2. The wear component (20) as defined by claim 1, wherein said diamond film has a thermal conductivity of at least 9 W/cm°K.

3. The wear component (20) as defined by claim 1, wherein said thermal conductivity of said synthetic diamond film is less than about 9 W/cm°K and said equivalent strain is at least 0.10 percent.

4. The wear component (20) as defined by one of claims 1 to 3, wherein said synthetic diamond film comprises CVD diamond film.

5. The wear component (20) as defined by one of claims 1 to 4, wherein said base surface (24) comprises tungsten carbide, and said synthetic diamond film is brazed to said base surface.

6. The wear component (20) as defined by one of claims 1 to 5, wherein said wear component (20) is a cutting component, and wherein said diamond film comprises a cutting surface applied on a base surface of a cutting tool.

7. A method of making a wear component, comprising the steps of:

   providing a base surface;

   producing a synthetic diamond film having a thickness of at least 20 μm and an equivalent strain of at least 0.08 percent by

   depositing synthetic diamond by chemical vapor deposition utilizing initial deposition parameters;

   monitoring the equivalent strain of the synthetic diamond;

   modifying at least one of said deposition parameters when the equivalent strain of the synthetic diamond is less than a predetermined percentage; and

   depositing further synthetic diamond utilizing the modified deposition parameters, and

   applying said diamond film to said base surface.

8. The method as defined by claim 7, wherein said diamond film has a thermal conductivity of at least 9 W/cm°K.

9. The method as defined by claim 7, wherein said thermal conductivity of said synthetic diamond film is less than 9 W/cm°K and said equivalent strain is at least 0.10 percent.

10. The method as defined by claim 7, wherein said step of producing a synthetic diamond film comprises producing said film by plasma deposition.

11. The method as defined by one of claims 7 to 10, wherein said producing and applying steps comprise depositing said synthetic diamond directly on said base surface.

12. The method as defined by one of claims 7 to 11, wherein said synthetic diamond film has a thickness of at least 200 µm, and wherein said step of applying said film to said base surface comprises mounting said film on said base surface using a mounting medium.

13. The method as defined by claim 12, wherein said mounting medium comprises a braze, and wherein said mounting step comprises brazing said diamond film to said base surface.

14. The method as defined by one of claims 7 to 13, wherein said base surface comprises tungsten carbide.

15. The method as defined by one of claims 7 to 14, wherein said wear component is a cutting component, and wherein said diamond film comprises a cutting surface applied on a base surface of a cutting tool.

16. A method for producing synthetic diamond for use as a wear surface, comprising the steps of:

    depositing synthetic diamond by chemical vapor deposition utilizing initial deposition parameters;

    monitoring the equivalent strain of the synthetic diamond;

    modifying at least one of said deposition parameters when the equivalent strain of the synthetic diamond is less than a predetermined percentage; and

    depositing further synthetic diamond utilizing the modified deposition parameters.

17. The method as defined by claim 16, wherein said predetermined equivalent strain percentage is at least 0.08 percent.

18. The method as defined by claim 16 or 17, further comprising monitoring the thermal conductivity of said synthetic diamond, and modifying said at least one deposition parameter when said thermal conductivity is less than a predetermined magnitude.

19. The method as defined by one of claims 16 to 18, wherein said at least one deposition parameter is deposition temperature.

20. The method as defined by one of claims 16 to 19, wherein said modifying step comprises increasing the deposition temperature.

21. The method as defined by one of claims 16 to 20, wherein said chemical vapor deposition utilizes methane and hydrogen feedstock gases, and wherein said deposition parameters comprise at least one parameter selected from the group consisting of the ratio of feedstock gases and the deposition temperature.

22. The method as defined by one of claims 16 to 21, further comprising applying said further synthetic diamond to a wear component base to form a wear component.

**Patentansprüche**

1. Verschleißkomponente (20), enthaltend:

    eine Basisfläche; und
    einen auf der Basisfläche angebrachten synthetischen Diamantfilm, wobei der Diamantfilm eine Dicke von wenigstens 200 µm und eine Äquivalenzdeformierung von wenigstens 0,08 Prozent aufweist, wobei der eine Äquivalenzdeformierung von wenigstens 0,08 Prozent aufweisende synthetische Diamantfilm durch die folgenden Schritte erhältlich ist:

Aufbringung von synthetischem Diamant durch chemische Dampfabscheidung unter Anwendung anfänglicher Aufbringungsparameter;

Überwachung der Äquivalenzdeformierung des synthetischen Diamants;

Modifizierung wenigstens einer der Aufbringungsparameter, wenn die Äquivalenzdeformierung des synthetischen Diamants unter einem vorbestimmten Prozentsatz liegt; und

Aufbringung von weiterem synthetischen Diamant unter Anwendung der modifizierten Aufbringungsparameter.

2. Verschleißkomponente (20) gemäß Anspruch 1, bei der der Diamantfilm eine Wärmeleitfähigkeit von wenigstens 9 W/cm°K aufweist.

3. Verschleißkomponente (20) gemäß Anspruch 1, bei der die Wärmeleitfähigkeit des synthetischen Diamantfilms weniger als etwa 9 W/cm°K und die Äquivalenzdeformierung wenigstens 0,10 Prozent beträgt.

4. Verschleißkomponente (20) gemäß einem der Ansprüche 1 bis 3, bei dem der synthetische Diamantfilm einen CVD-Diamantfilm umfaßt.

5. Verschleißkomponente (20) gemäß einem der Ansprüche 1 bis 4, bei dem die Basisfläche (24) Wolframcarbid aufweist und der synthetische Diamantfilm auf die Basisfläche gelötet ist.

6. Verschleißkomponente (20) gemäß einem der Ansprüche 1 bis 5, bei dem die Verschleißkomponente (20) eine Schneidkomponente ist und der Diamantfilm eine Schneidfläche aufweist, die auf einer Basisfläche eines Schneidwerkzeugs angebracht ist.

7. Verfahren zur Herstellung einer Verschleißkomponente, umfassend die Schritte:

Bereitstellung einer Basisfläche;

Herstellung eines synthetischen Diamantfilms mit einer Dicke von wenigstens 20 μm und einer Äquivalenzdeformierung von wenigstens 0,08 Prozent durch

Aufbringung von synthetischem Diamant durch chemische Dampfabscheidung unter Anwendung anfänglicher Aufbringungsparameter;

Überwachung der Äquivalenzdeformierung des synthetischen Diamants;

Modifizierung wenigstens einer der Aufbringungsparameter, wenn die Äquivalenzdeformierung des synthetischen Diamants unter einem vorbestimmten Prozentsatz liegt; und

Aufbringung von weiterem synthetischen Diamant unter Anwendung der modifizierten Aufbringungsparameter,

Anbringung des Diamantfilms auf der Basisfläche.

8. Verfahren gemäß Anspruch 7, bei dem der Diamantfilm eine Wärmeleitfähigkeit von wenigstens 9 W/cm°K aufweist.

9. Verfahren gemäß Anspruch 7, bei dem die Wärmeleitfähigkeit des synthetischen Diamantfilms weniger als 9 W/cm°K und die Äquivalenzdeformierung wenigstens 0,10 Prozent beträgt.

10. Verfahren gemäß Anspruch 7, bei dem der Schritt der Herstellung eines synthetischen Diamantfilms die Herstellung des Films mittels Plasmaabscheidung umfaßt.

**11.** Verfahren gemäß einem der Ansprüche 7 bis 10, bei dem die Herstellungs- und Aufbringungsschritte die Aufbringung des synthetischen Diamants direkt auf der Basisfläche umfaßt.

**12.** Verfahren gemäß einem der Ansprüche 7 bis 11, bei dem der synthetische Diamantfilm eine Dicke von wenigstens 200 µm aufweist und der Schritt der Anbringung des Films auf der Basisfläche die Befestigung des Films auf der Basisfläche unter Verwendung eines Befestigungsmediums umfaßt.

**13.** Verfahren gemäß Anspruch 12, bei dem das Befestigungsmedium ein Lötmittel ist und der Befestigungsschritt das Löten des Diamantfilms auf die Basisfläche umfaßt.

**14.** Verfahren gemäß einem der Ansprüche 7 bis 13, bei dem die Basisfläche Wolframcarbid umfaßt.

**15.** Verfahren gemäß einem der Ansprüche 7 bis 14, bei dem die Verschleißkomponente eine Schneidkomponente ist und der Diamantfilm eine auf der Basisfläche eines Schneidwerkzeugs angebrachte Schneidfläche aufweist.

**16.** Verfahren zur Herstellung von synthetischem Diamant zur Verwendung als eine Verschleißfläche, umfassend die Schritte:

Aufbringung von synthetischem Diamant durch chemische Dampfabscheidung unter Anwendung anfänglicher Aufbringungsparameter;

Überwachung der Äquivalenzdeformierung des synthetischen Diamants;

Modifizierung wenigstens einer der Aufbringungsparameter, wenn die Äquivalenzdeformierung des synthetischen Diamants unter einem vorbestimmten Prozentsatz liegt; und

Aufbringung von weiterem synthetischen Diamant unter Anwendung der modifizierten Aufbringungsparameter.

**17.** Verfahren gemäß Anspruch 16, bei dem der bestimmte Äquivalenzdeformierungsprozentsatz wenigstens 0,08 Prozent beträgt.

**18.** Verfahren gemäß Anspruch 16 oder 17, das des weiteren die Überwachung der Wärmeleitfähigkeit des synthetischen Diamants umfaßt sowie die Modifizierung des wenigstens einen Aufbringungsparameters, wenn die Wärmeleitfähigkeit weniger als die vorbestimmte Größe beträgt.

**19.** Verfahren gemäß einem der Ansprüche 16 bis 18, bei dem der wenigstens eine Aufbringungsparameter die Aufbringungstemperatur ist.

**20.** Verfahren gemäß einem der Ansprüche 16 bis 19, bei dem der Modifizierungsschritt die Erhöhung der Aufbringungstemperatur umfaßt.

**21.** Verfahren gemäß einem der Ansprüche 16 bis 20, bei dem bei der chemischen Dampfabscheidung Methan- und Wasserstoffeduktgase eingesetzt werden und die Aufbringungsparameter wenigstens einen Parameter, ausgewählt aus der Gruppe bestehend aus dem Verhältnis der Eduktgase und der Aufbringungstemperatur, umfassen.

**22.** Verfahren gemäß einem der Ansprüche 16 bis 21, das des weiteren die Aufbringung des weiteren synthetischen Diamants auf einer Verschleißkomponentenbasis zur Bildung einer Verschleißkomponente aufweist.

**Revendications**

**1.** Pièce d'usure (20), comprenant :

une surface de base ; et
un film de diamant synthétique monté sur ladite surface de base, ledit film de diamant ayant une épaisseur d'au moins 200 µm et une déformation équivalente d'au moins 0,08 %, le film de diamant synthétique ayant une déformation équivalente d'au moins 0,08 % pouvant être obtenu par les étapes suivantes :

- le dépôt du diamant synthétique par dépôt chimique en phase vapeur en utilisant des paramètres initiaux de dépôt ;
- le contrôle de la déformation équivalente du diamant synthétique ;
- la modification de l'un au moins desdits paramètres de dépôt lorsque la déformation équivalente du diamant synthétique est inférieure à un pourcentage prédéterminée ; et
- le dépôt de davantage de diamant synthétique en utilisant les paramètres de dépôt modifiés.

2. Pièce d'usure (20) selon la revendication 1, dans laquelle ledit film de diamant à une conductivité thermique d'au moins 9 W/cm°K.

3. Pièce d'usure (20) selon la revendication 1, dans laquelle ladite conductivité thermique dudit film de diamant synthétique est inférieure à environ 9 W/cm°K et ladite déformation équivalente est d'au moins 0,10 %.

4. Pièce d'usure (20) selon l'une des revendications 1 à 3, dans laquelle ledit film de diamant synthétique est constitué d'un film en diamant obtenu par dépôt chimique en phase vapeur.

5. Pièce d'usure (20) selon l'une des revendications 1 à 4, dans laquelle ladite surface de base (24) est formée de carbure de tungstène et ledit film de diamant synthétique est brasé sur ladite surface de base.

6. Pièce d'usure (20) selon l'une des revendications 1 à 5, dans laquelle ladite pièce d'usure (20) est une pièce de coupe, et dans laquelle ledit film de diamant réalise une surface de coupe appliquée sur une surface de base d'un outil de coupe.

7. Procédé de fabrication d'une pièce d'usure, comprenant les étapes suivantes :

   la fourniture d'une surface de base ;
   la production d'un film de diamant synthétique ayant une épaisseur d'au moins 20 µm et une déformation équivalente d'au moins 0,08 % par

   - dépôt du diamant synthétique par dépôt chimique en phase vapeur en utilisant des paramètres de dépôt initiaux ;
   - contrôle de la déformation équivalente du diamant synthétique ;
   - modification de l'un au moins desdits paramètres de dépôt lorsque la déformation équivalente du diamant synthétique est inférieure à un pourcentage prédéterminé ; et
   - dépôt de davantage de diamant synthétique en utilisant les paramètres de dépôt modifiés, et

   l'application dudit film de diamant sur ladite surface de base.

8. Procédé selon la revendication 7, dans lequel ledit film de diamant a une conductivité thermique d'au moins 9 W/cm°K.

9. Procédé selon la revendication 7, dans lequel ladite conductivité thermique dudit film de diamant synthétique est inférieure à 9 W/cm°K et ladite déformation équivalente est d'au moins 0,10 %.

10. Procédé selon la revendication 7, dans lequel ladite étape de production du film de diamant synthétique comprend la production dudit film par dépôt de plasma.

11. Procédé selon l'une des revendications 7 à 10, dans lequel lesdites étapes de production et d'application comprennent le dépôt dudit diamant synthétique directement sur ladite surface de base.

12. Procédé selon l'une des revendications 7 à 11, dans lequel ledit film de diamant synthétique a une épaisseur d'au moins 200 µm et dans lequel ladite étape d'application dudit film sur ladite surface de base comprend le montage dudit film sur ladite surface de base en utilisant un milieu de montage.

13. Procédé selon la revendication 12, dans lequel ledit milieu de montage est constitué d'une brasure et dans lequel ladite étape de montage consiste en le brasage dudit film de diamant sur ladite surface de base.

14. Procédé selon l'une des revendications 7 à 13, dans lequel ladite surface de base est formée de carbure de tungstène.

**15.** Procédé selon l'une des revendications 7 à 14, dans lequel ladite pièce d'usure est une pièce de coupe et dans lequel ledit film de diamant réalise une surface de coupe appliquée sur une surface de base d'un outil de coupe.

**16.** Procédé de production de diamant synthétique destiné à être utilisé comme surface d'usure, comprenant les étapes suivantes :

le dépôt de diamant synthétique par dépôt chimique en phase vapeur en utilisant des paramètres de dépôt initiaux ;
le contrôle de la déformation équivalente dudit diamant synthétique ;
la modification de l'un au moins desdits paramètres de dépôt lorsque la déformation équivalente dudit diamant synthétique est inférieure à un pourcentage prédéterminé ; et
le dépôt de davantage de diamant synthétique en utilisant les paramètres de dépôt modifiés.

**17.** Procédé selon la revendication 16, dans lequel ledit pourcentage de déformation équivalente prédéterminé est d'au 0,08 %.

**18.** Procédé selon la revendication 16 ou 17, comprenant en outre le contrôle de la conductivité thermique dudit diamant synthétique et la modification dudit au moins un paramètre de dépôt lorsque ladite conductivité thermique est inférieure à une amplitude prédéterminée.

**19.** Procédé selon l'une des revendications 16 à 18, dans lequel ledit au moins un paramètre de dépôt est la température de dépôt.

**20.** Procédé selon l'une des revendications 16 à 19, dans lequel ladite étape de modification comprend l'augmentation de la température de dépôt.

**21.** Procédé selon l'une des revendications 16 à 20, dans lequel ledit dépôt chimique en phase vapeur utilise du méthane et de l'hydrogène comme gaz d'alimentation, et dans lequel lesdits paramètres de dépôt comprennent au moins un paramètre choisi dans le groupe consistant en le rapport entre les gaz d'alimentation et la température de dépôt.

**22.** Procédé selon l'une des revendications 16 à 21, comprenant en outre l'application dudit diamant synthétique supplémentaire à une base de pièce d'usure pour former une pièce d'usure.

FIG. 1

24    20    28

FIG. 2

24    20    28

26

FIG. 3

FIG. 4

```
        ┌──────────────────┐
        │ PRODUCE          │
        │ THICK FILM       │
        │ CVD DIAMOND      │
        │               510│
        └──────────────────┘
                 │
                 ▼
        ┌──────────────────┐
        │ MEASURE          │
        │ EQUIVALENT       │
        │ STRIAN           │
        │               520│
        └──────────────────┘
                 │
                 ▼
        ┌──────────────────┐
        │ MEASURE          │
        │ THERMAL          │
        │ CONDUCTIVITY     │
        │               530│
        └──────────────────┘
                 │
                 ▼
```

NO ◄─────   MEASUREMENT(S) ABOVE MINIMUMS ?  540   ─────► YES

REJECT FOR APPLICATION

ACCEPT FOR APPLICATION

FIG. 5